# EUROPÄISCHE PATENTANMELDUNG

(11) **EP 2 442 630 A1**
(43) Veröffentlichungstag der Anmeldung: **18.04.2012**
(21) Anmeldenummer: 10187913.8
(22) Anmeldetag: 18.10.2010
(51) Int. Cl.: H05K 7/20

(54) **Wärmeleitpad**

(71) Anmelder: Siemens Aktiengesellschaft, 80333 München (DE)
(72) Erfinder: Hirth, Joachim, 76135, Karlsruhe (DE)

(57) **Zusammenfassung**

Die Erfindung betrifft ein Wärmeleitpad, welches zur Verbesserung der Ableitung von Verlustwärme mindestens eines auf einer Leiterplatte (7) angeordneten elektronischen Bauteils (5) vorgesehen ist, wobei das Wärmeleitpad (1) zwischen dem mindestens einen Bauteil (5) und einem Kühlkörper (3) angeordnet ist. Es wird vorgeschlagen, das Wärmeleitpad so zu modifizieren, dass einerseits der Druck beim Anschrauben der Leiterplatte (7) auf den Kühlkörper (3) begrenzt und andererseits eine noch gute thermische Kontaktierung mit dem elektronischen Bauteil (5) sichergestellt wird.

## Beschreibung

Die Erfindung betrifft ein Wärmeleitpad, welches zur Verbesserung der Ableitung von Verlustwärme mindestens eines auf einer Leiterplatte angeordneten elektronischen Bauteils vorgesehen ist, wobei das Wärmeleitpad zwischen dem mindestens einen Bauteil und einem Kühlkörper angeordnet ist. Darüber hinaus betrifft die Erfindung ein elektronisches Gerät mit mindestens einer mit elektronischen Bauteilen versehenen Leiterplatte, mit einem Kühlkörper und einem zwischen der Leiterplatte und dem Kühlkörper angeordneten Wärmeleitpad.

Aus dem Siemens Katalog "ST 80 / ST PC", Seiten 5/61 bis 5/95, Ausgabe 2010 ist ein so genannter Industrie PC bekannt, dessen Gehäuse als Kühlkörper ausgebildet ist. Dieser Kühlkörper ist zur Ableitung von Wärme vorgesehen, die auf einer Leiterplatte angeordnete elektronische Bauteile bzw. Bauelemente während des Betriebs des Industrie PCs erzeugen. Eine Wand des Gehäuses ist mit Abstandsbolzen versehen, die zum Befestigen der Leiterplatte an dieser Wand mittels Schrauben vorgesehen sind. Ein guter Wärmeübergang zwischen den Bauteilen und dieser Wand wird dadurch ermöglicht, indem zwischen der Gehäusewand und der Leiterplatte ein flexibles Wärmeleitpad angeordnet ist. Dieses Wärmeleitpad bewirkt, dass aufgrund von Höhentoleranzen der Abstandsbolzen, aufgrund von Unebenheiten der Leiterplatte und/oder unterschiedlicher Höhen der Bauelemente die unterschiedlichen Abstände zwischen den Bauelementen und der Gehäusewand ausgeglichen werden. Dabei ist es einerseits erwünscht, eine großflächige und gute thermische Kontaktierung bzw. eine gute Wärmeableitung sicherzustellen, was mittels eines dünnen Wärmeleitpads erzielt werden kann; andererseits ist es erwünscht, den Druck auf die Leiterplatte bzw. die mechanische Belastung der Leiterplatte beim Anschrauben an die Gehäusewand zu begrenzen, um dadurch die Leiterplatte nicht zu stark zu deformieren, was mittels eines dick ausgebildeten Wärmeleitpads bewirkt werden kann. Um diese sich widersprechenden Forderungen erfüllen zu können, kann aushärtbares Füllmaterial eingesetzt werden, was allerdings eine aufwendige Dosiertechnik erfordert.

Der Erfindung liegt die Aufgabe zugrunde, ein Wärmeleitpad der eingangs genannten Art so zu modifizieren, dass einerseits der Druck beim Anschrauben der Leiterplatte auf einen Kühlkörper begrenzt und andererseits eine noch gute thermische Kontaktierung mit dem elektronischen Bauteil bzw. der Leiterplatte sichergestellt wird. Darüber hinaus ist ein elektronisches Gerät mit einem derartigen Wärmeleitpad anzugeben.

Diese Aufgabe wird im Hinblick auf das Wärmeleitpad durch die im kennzeichnenden Teil des Anspruchs 1 angegebenen, bezüglich der Anordnung mit den im Anspruch 2 angegebenen Maßnahmen gelöst.

Die Erfindung geht von der Idee aus, durch eine geometrische Umgestaltung eines Wärmeleitpads den Druck auf die Leiterplatte und das auf der Leiterplatte angeordnete Wärmeleitpad beim Anschrauben bzw. Verpressen der Leiterplatte auf einen Kühlkörper bei minimaler Verringerung der thermischen Kontaktierung zu reduzieren. Dies wird dadurch ermöglicht, dass das Wärmeleitpad mit Ausnehmungen versehen ist, wodurch der Druck bzw. die mechanische Belastung erheblich reduziert, die thermische Kontaktierung mit dem Bauteil bzw. mit der Leiterplatte allerdings nur unerheblich verringert wird. Während der Verpressung kann das Material des Wärmeleitpads in die Ausnehmungen "ausweichen", die Ausnehmungen "fließen" zusammen und werden kleiner, wodurch die gute thermische Kontaktierung bzw. Wärmeableitung durch die unwesentlich verringerte Oberfläche des Wärmeleitpads weitgehend erhalten bleibt.

In einer Ausgestaltung der Erfindung ist vorgesehen, Ausnehmungen des Wärmeleitpads lochmusterartig anzuordnen, wodurch im Rahmen der Verpressung eine im Wesentlichen gleichmäßige Oberfläche des Wärmeleitpads erzielt wird.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1: ein Wärmeleitpad und
- Figur 2: Teile eines elektronischen Gerätes.

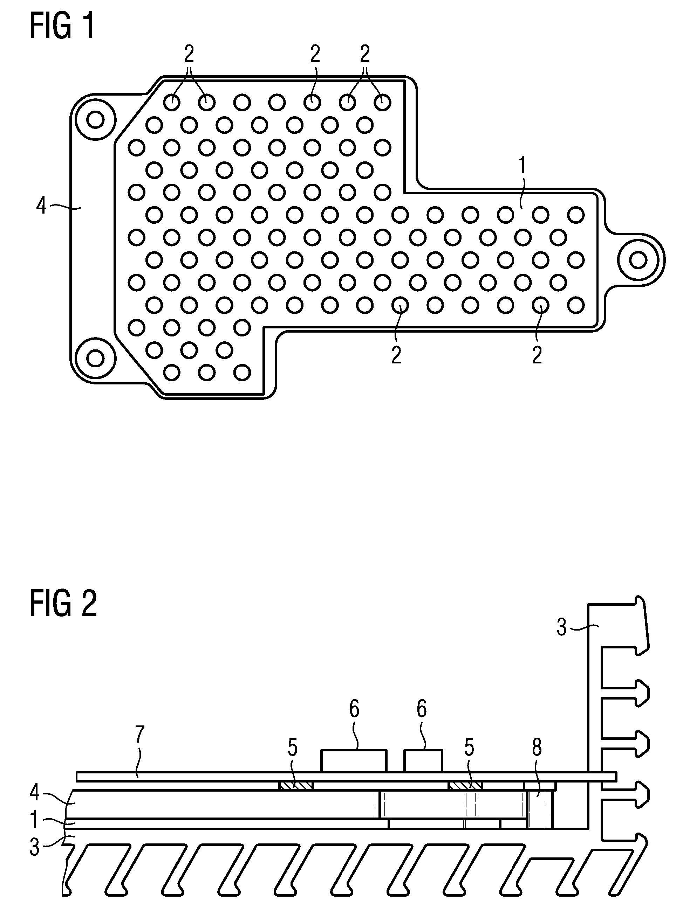

Die in den Figuren 1 und 2 gleichen Teile sind mit gleichen Bezugszeichen versehen.

Ein mit 1 bezeichnetes Wärmeleitpad weist lochmusterartige Ausnehmungen 2 auf, wobei das Wärmeleitpad 1 zwischen einem Kühlkörper 3 und einem so genannten Heatspreader (Hitzeverteiler) 4 angeordnet ist. Der Kühlkörper 3 ist im vorliegenden Ausführungsbeispiel ein Gehäuse eines Industrie PCs, in welchem eine mit elektronischen Bauteilen bzw. Bauelementen 5 und sonstigen Bauteilen 6, beispielsweise Bauteile in Form von Anschlusssteckern, bestückte Leiterplatte 7 eingebaut ist. Der Kühlkörper 3 ist zur Ableitung der Wärme vorgesehen, welche die elektronischen Bauteile 5 während des Betriebs des Industrie PCs erzeugen. Eine Wand des Kühlkörpers 3 weist Abstandsbolzen 8 auf, die zum Befestigen der Leiterplatte 7 an dieser Wand mittels Schrauben vorgesehen sind. Das Wärmeleitpad 1 gleicht unterschiedliche Abstände zwischen den Bauteilen 5 und dem Kühlkörper 3 aus, wobei die Abstände aufgrund von Höhentoleranzen der Abstandsbolzen 8, aufgrund von Unebenheiten der Leiterplatte 7 und/oder des Heatspreaders 4 und/oder aufgrund unterschiedlicher Höhen der Bauteile 5 entstehen.

Das mit den lochmusterartigen Ausnehmungen 2 versehene Wärmeleitpad 1 reduziert den Druck auf die Leiterplatte 7 und auf das Wärmeleitpad 1 beim Anschrauben bzw. Verpressen der Leiterplatte 7 auf den Kühlkörper 3, wobei die Wärmeableitung bzw. die thermische Kontaktierung der Leiterplatte 7 bzw. der Bauteile 5 mit dem Kühlkörper minimal verringert wird. Während der Verpressung weicht das Material des Wärmeleitpads 1 in die Ausnehmungen 5 aus, die Ausnehmungen 5 "fließen" zusammen und werden kleiner, wodurch die gute thermische Kontaktierung bzw. Wärmeableitung durch die unwesentlich verringerte Oberfläche des Wärmeleitpads 1 weitgehend erhalten bleibt.

In einem praktischen Ausführungsbeispiel der Erfindung bewirkt die durch die Ausnehmungen verringerte Oberfläche eines Wärmeleitpads im Vergleich zu einem Wärmeleitpad ohne Ausnehmungen eine Verminderung der Fläche um 21 %, was sich unwesentlich nachteilig auf den Wärmeübergang auswirkt; allerdings reduziert sich aufgrund der Ausnehmungen der Druck bzw. die mechanische Belastung auf die Leiterplatte um ca. 58 %, was bedeutet, dass sich der Druck bzw. die mechanische Belastung überproportional zur Verminderung der thermischen Kontaktierung reduziert.

## Patentansprüche

1. Wärmeleitpad, welches zur Verbesserung der Ableitung von Verlustwärme mindestens eines auf einer Leiterplatte (7) angeordneten elektronischen Bauteils (5) vorgesehen ist, wobei das Wärmeleitpad (1) zwischen dem mindestens einen Bauteil (5) und einem Kühlkörper (3) angeordnet ist, **dadurch gekennzeichnet, dass** das Wärmeleitpad (1) mit einer Vielzahl von Ausnehmungen (2) versehen ist.

2. Wärmeleitpad nach Anspruch 1, **dadurch gekennzeichnet, dass** die Ausnehmungen (2) lochmusterartig angeordnet sind.

3. Elektronisches Gerät mit einer mit elektronischen Bauteilen (5) versehenen Leiterplatte (7), mit einem Kühlkörper (3) und einem zwischen der Leiterplatte (7) und dem Kühlkörper (3) angeordneten Wärmeleitpad (1) nach Anspruch 1 oder 2.
